# EUROPÄISCHE PATENTANMELDUNG

(11) **EP 1 079 529 A2**
(43) Veröffentlichungstag der Anmeldung: **28.02.2001**
(21) Anmeldenummer: 00115384.0
(22) Anmeldetag: 15.07.2000
(51) Int. Cl.: H03M 13/37, H03M 13/29

(54) **Verfahren und Vorrichtung zur Dekodierung von über einen Übertragungskanal übertragenen kanalkodierten Daten**

(30) Priorität: 27.08.1999 DE 19940666
(71) Anmelder: ROBERT BOSCH GMBH, 70442 Stuttgart (DE)
(72) Erfinder: Laumen, Josef, 31141 Hildesheim (DE)

(57) **Zusammenfassung**

Es werden ein Verfahren und eine Vorrichtung zur Dekodierung von über einen Übertragungskanal (5) übertragenen kanalkodierten Daten vorgeschlagen, das bzw. die eine Verringerung des Leistungsverbrauchs ermöglicht. Die Daten werden vor der Übertragung zunächst mit einem äußeren Kanalkode, vorzugsweise einem Fire-Kode kodiert, der sowohl eine Fehlererkennung als auch eine Fehlerkorrektur bei der Dekodierung ermöglicht. Die Daten werden anschließend mit einem inneren Kanalkode, vorzugsweise einem Turbo-Kode, kodiert. Bei der Dekodierung der vom Übertragungskanal (5) empfangenen kanalkodierten Daten werden in einem ersten Schritt der innere Kanalkode und anschließend in einem zweiten Schritt der äußere Kanalkode dekodiert. Bei der Dekodierung des äußeren Kanalkodes wird zumindest ein Teil der nach der Dekodierung des inneren Kanalkodes verbleibenden Restfehler korrigiert. In einem dritten Schritt wird geprüft, ob die Daten korrekt dekodiert wurden. Für den Fall, in dem die Prüfung ergibt, daß die Daten nicht korrekt dekodiert wurden, werden die Schritte 1 bis 3 wiederholt. Andernfalls wird die Dekodierung abgebrochen.

## Beschreibung

### Stand der Technik

Die Erfindung geht von einem Verfahren und von einer Vorrichtung zur Dekodierung von über einen Übertragungskanal übertragenen kanalkodierten Daten nach der Gattung der unabhängigen Ansprüche aus.

Aus der noch nicht vorveröffentlichten deutschen Patentanmeldung mit dem Aktenzeichen 198 46 721 sind bereits ein Verfahren und eine Vorrichtung zur Dekodierung von über einen Übertragungskanal übertragenen kanalkodierten Daten bekannt. Dabei werden die Daten vor der Übertragung zunächst einer Blockkodierung unterzogen, die auch als äußere Kodierung bezeichnet wird. Dabei kann ein variabler Blockkode verwendet werden, der ein flexibles Abgleichen zwischen Fehlererkennung und Fehlerkorrektur erlaubt. Als Blockkode kann dabei der sogenannte Fire-Code verwendet werden. Anschließend werden die so kodierten Daten einer inneren Kodierung, typischerweise einer Faltungskodierung oder Turbokodierung, unterzogen. Bei der Dekodierung erfolgt zunächst eine innere Dekodierung und im darauffolgenden Schritt eine Blockdekodierung. Bei der Blockdekodierung ist dabei eine Korrektur von Fehlentscheidungen des inneren Dekoders möglich.

### Vorteile der Erfindung

Das erfindungsgemäße Verfahren und die erfindungsgemäße Vorrichtung mit den Merkmalen der unabhängigen Ansprüche haben demgegenüber den Vorteil, daß in einem dritten Schritt bei der Dekodierung geprüft wird, ob die Daten korrekt dekodiert wurden, daß für den Fall, in dem die Prüfung ergibt, daß die Daten nicht korrekt dekodiert wurden, die Dekodierung des inneren Kanalcodes, die Dekodierung des äußeren Kanalcodes und die Prüfung auf korrekte Dekodierung der Daten wiederholt werden, und daß andernfalls die Dekodierung abgebrochen wird. Auf diese Weise wird eine iterative Dekodierung bewirkt, bei der die einzelnen Dekodierschritte mehrfach durchlaufen werden, so daß die vom Übertragungskanal empfangenen Daten nach Beendigung der iterativen Dekodierung möglichst fehlerfrei einer Weiterverarbeitung zugeführt werden können. Durch die Verwendung eines äußeren Kanalcodes, der sowohl eine Fehlererkennung als auch eine Fehlerkorrektur bei der Dekodierung ermöglicht, wird die Zahl der für die Erzielung eines fehlerfreien Empfangssignals erforderlichen Iterationsschritte bei der Dekodierung minimiert. Dies ist besonders dann von Vorteil, wenn die Dekodierung in mobilen Telekommunikationsendgeräten durchgeführt wird, da eine Reduzierung der Anzahl der erforderlichen Iterationsschritte zu einer Senkung des Leistungsverbrauchs und damit zu einer längeren Betriebszeit des mobilen Telekommunikationsendgerätes bei Verwendung eines Akkumulators führt.

Durch die in den Unteransprüchen aufgeführten Maßnahmen sind vorteilhafte Weiterbildungen und Verbesserungen des Verfahrens bzw. der Vorrichtung gemäß den unabhängigen Ansprüchen möglich.

Besonders vorteilhaft ist es dabei, daß die Dekodierung abgebrochen wird, wenn im dritten Schritt festgestellt wird, daß eine vorgegebene Anzahl von Iterationsschritten erreicht wurde. Auf diese Weise wird sichergestellt, daß die iterative Dekodierung beendet und nicht übermäßig oft wiederholt wird, sollten die empfangenen Daten nicht zuvor korrekt dekodiert worden sein. Auf diese Weise wird besonders bei Verwendung der Dekodierung in mobilen Telekommunikationsendgeräten der für die iterative Dekodierung erforderliche Leistungsverbrauch beschränkt. Durch entsprechende Vorgabe der Anzahl von maximal für die Dekodierung zugelassenen Iterationsschritten kann ein Kompromiß zwischen möglichst geringem Leistungsverbrauch und möglichst korrekter Dekodierung der Daten nach den Bedürfnissen des Benutzers des entsprechenden mobilen Telekommunikationsendgerätes erzielt werden.

### Zeichnung

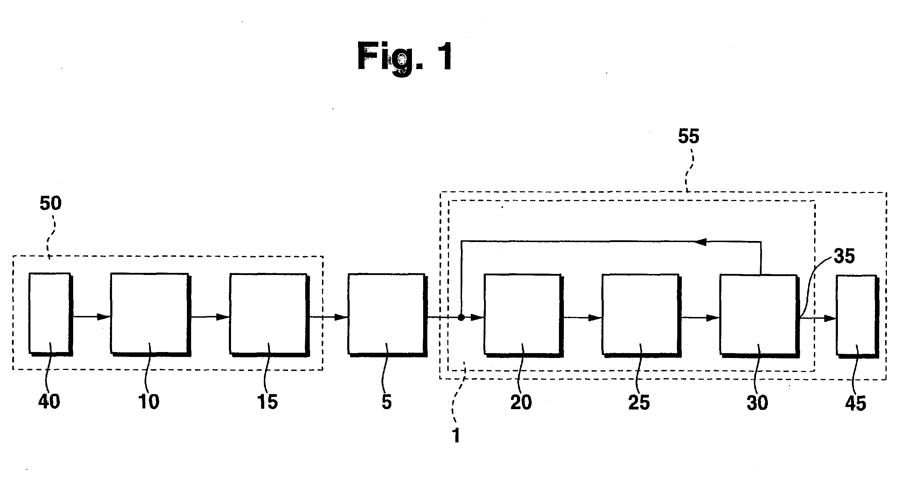

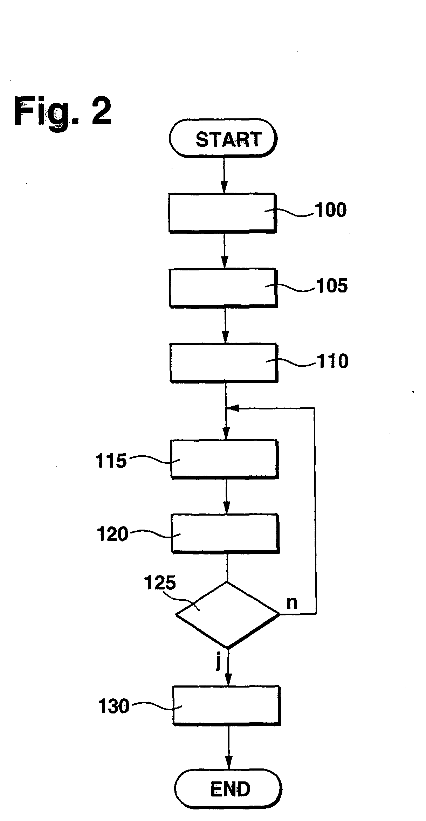

Ein Ausführungsbeispiel der Erfindung ist in der Zeichnung dargestellt und in der nachfolgenden Beschreibung näher erläutert. Es zeigen Figur 1 ein Blockschaltbild für eine Datenübertragung von einer Datenquelle zu einer Datensenke und Figur 2 einen Ablaufplan zur Beschreibung der Datenübertragung gemäß dem Blockschaltbild nach Figur 1.

### Beschreibung des Ausführungsbeispiels

Die Kanalkodierung dient der Korrektur von Fehlern, welche bei einer Datenübertragung über einen fehlerhaften Übertragungskanal auftreten. Insbesondere solche Verfahren der Kanalkodierung, welche auf Faltungskodes oder einer Verkettung von Faltungskodes basieren, sind wegen ihrer guten Leistungsfähigkeit weit verbreitet, beispielsweise im GSM-System (Global System for mobile Communications) gemäß der Veröffentlichung 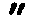 GSM Global System for mobile Communication" von J. Eberspächer und H. J. Vögel, 1997. Faltungskodes liefern in der Regel jedoch keine Aussage über die Korrektheit der dekodierten Daten. Da es teilweise vorkommt, daß empfangene Daten trotz der Kanalkodierung im Empfänger nicht den Quelldaten des Senders entsprechen, wird häufig zusätzlich ein CRC-Kode (Cyclic Redundancy Check) gemäß der genannten Veröffentlichung verwendet. Durch Verwendung des CRC-Codes können fehlerhaft decodierte Datenblöcke im Empfänger erkannt und verworfen bzw. neu angefordert werden. Dabei stellt der Faltungskode einen inneren Kanalkode und der CRC-Kode einen äußeren Kanalkode dar. Aus der Veröffentlichung 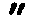 Near Optimum Error Correcting Coding and Decoding: Turbo-Codes" von C. Berrou und A. Glavieux, IEEE Trans. On Communications, Vol. 44, No. 10, October 1996 ist es bekannt, als inneren Kanalkode einen Turbo-Kode zu verwenden. Dabei ist für die Dekodierung von Turbo-Kodes ein iteratives Dekodierverfahren bekannt. Kennzeichnend für die iterative Dekodierung ist die Rückkopplung der dekodierten Daten zum Eingang des Dekoders, um diese Daten dann wiederholt oder iterativ zu dekodieren. Um diese wiederholte Rückführung und Dekodierung der Daten nicht übermäßig oft durchzuführen und damit übermäßig Leistung zu verbrauchen, muß ein Abbruchkriterium gefunden werden. Aus der genannten Veröffentlichung von J. Hagenauer ist dabei als einfachstes Abbruchkriterium die Vorgabe einer maximalen Anzahl von Iterationsschritten bekannt. Nach Abschluß der iterativen Dekodierung des inneren Kanalkodes werden die so dekodierten Daten anschließend einer Dekodierung des äußeren Kanalkodes, beispielsweise des CRC-Kodes unterzogen. Nach der Dekodierung des äußeren Kanalkodes können die so dekodierten empfangenen Daten einer Weiterverarbeitung zugeführt werden.

In Figur 1 ist das Blockschaltbild einer Datenübertragung von einer Datenquelle 40 zu einer Datensenke 45 gemäß der Erfindung dargestellt. Die Übertragung der Daten von der Datenquelle 40 zur Datensenke 45 kann beispielsweise in einem mobilen Kommunikationssystem beispielsweise nach dem GSM-Standard (Global System for mobile Communications) oder nach dem UMTS-Standard (Universal mobile Telecommunication System) erfolgen. Die Übertragung erfolgt dabei über einen Übertragungskanal 5, der bei Verwendung eines mobilen Kommunikationssystems als Funkkanal ausgebildet sein kann. Vor der Übertragung der Daten von der Datenquelle 40 zur Datensenke 45 über den Übertragungskanal 5 werden die Daten der Datenquelle 40 zunächst einem äußeren Kanalkoder 10 und anschließend einem inneren Kanalkoder 15 zugeführt, bevor sie an den Übertragungskanal 5 abgesetzt werden. Die Datenquelle 40, der äußere Kanalkoder 10 und der innere Kanalkoder 15 können Bestandteile einer Sendeeinheit 50, die beispielsweise als Basisstation eines mobilen Kommunikationssystems ausgebildet ist, sein.

Dabei wird für die äußere Kanalkodierung im äußeren Kanalkoder 10 ein variabler Blockkode eingesetzt, der beispielsweise als sogenannter Fire-Code ausgebildet sein kann. Gemäß der Veröffentlichung 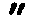 Fast Burst Error-Correction Scheme with Fire-Code", Wael Adi, IEEE Transactions on Computers, vol. c-33 no. 7, July 1984" ermöglicht dieser variable Blockkode ein flexibles Abgleichen zwischen Fehlererkennung und Fehlerkorrektur. Dabei können die Möglichkeiten der Fehlererkennung auf Kosten sinkender Korrekturfähigkeit ohne Änderung der Kodier- oder Dekodiermechanismen flexibel erhöht und überwacht werden und umgekehrt. Anstelle des CRC-Kodes wird also für die äußere Kanalkodierung der variable Blockkode verwendet. CRC-Kodes werden im allgemeinen lediglich zur Erkennung von Fehlentscheidungen bei der Dekodierung des inneren Kanalkodes eingesetzt, um fehlerhaft dekodierte Datenrahmen zu erkennen und als solche markieren zu können. Im Einsatz von variablen Blockkodes hingegen können sowohl dessen Fehlerkorrektur- als auch Fehlererkennungseigenschaften ausgenutzt werden. Solange die mittels des variablen Blockkodes hinzugefügte Redundanz nicht weniger Bits enthält als die Redundanz des CRC-Kodes, bietet der variable Blockkode mindestens äquivalente Fehlerschutzmöglichkeiten. Überschreitet die Redundanz des variablen Blockkodes die Redundanz des CRC-Kodes, so kann entweder die Zuverlässigkeit der Fehlererkennung weiter gesteigert werden oder aber eine zusätzliche Fehlerkorrektur ermöglicht werden. Der Einsatz des variablen Blockkodes als äußere Kanalkodierung empfiehlt sich dabei besonders in Übertragungssystemen mit variabler Datenrate entweder des Übertragungskanals 5 und/oder der Datenquelle 40. Der hier verwendete variable Blockkode soll dabei eine zusätzliche Fehlerkorrektur ermöglichen. Für die innere Kanalkodierung im inneren Kanalkoder 15 kann in herkömmlicher Weise beispielsweise ein Faltungskode oder ein Turbo-Kode verwendet werden. Die im äußeren Kanalkoder 10 und im inneren Kanalkoder 15 kodierten Daten der Datenquelle 40 werden dann über den Übertragungskanal 5 beispielsweise an eine Empfangseinheit 55, die beispielsweise als Mobiltelefon ausgebildet ist, übertragen, das eine Vorrichtung 1 zur iterativen Dekodierung und eine Datensenke 45 aufweist. Dabei werden die vom Übertragungskanal 5 empfangenen Daten zunächst einem inneren Kanaldekoder 20 zugeführt, der den inneren Kanalkode dekodiert. Die so dekodierten Daten werden anschließend einem äußeren Kanaldekoder 25 zugeführt. Der innere Kanaldekoder 20 und der äußere Kanaldekoder 25 sind Bestandteile der Vorrichtung 1 zur iterativen Dekodierung.

Empfangene Datenblöcke, welche nach der inneren Kanaldekodierung im inneren Kanaldekoder 20, der als Viterbi- oder als Maximum A Posteriori (MAP) -Dekoder ausgebildet sein kann, noch Restfehler aufgrund von Fehlentscheidungen des inneren Kanaldekoders 20 enthalten, werden nun im äußeren Kanaldekoder 25 zumindest zum Teil - anders als bei der Verwendung des CRC-Kodes - nicht nur als fehlerhaft erkannt, sondern sogar korrigiert. Nach der äußeren Kanaldekodierung des äußeren Kanalkodes im äußeren Kanaldekoder 25 werden die empfangenen Daten einer Auswerteeinheit 30 zugeführt, die ebenfalls Bestandteil der Vorrichtung 1 zur iterativen Dekodierung ist. In der Auswerteeinheit 30 wird geprüft, ob die empfangenen Daten nach der äußeren Kanaldekodierung noch fehlerhaft sind, also nicht korrekt dekodiert wurden. Ist dies der Fall, so werden die Daten wieder auf den inneren Kanaldekoder 20 rückgekoppelt und werden in einem weiteren Iterationsschritt erneut einer inneren und anschließend einer äußeren Kanaldekodierung wie beschrieben unterzogen. Jedes Durchlaufen oder erneute Durchlaufen des inneren Kanaldekoders 20, des äußeren Kanaldekoders 25 und der Auswerteeinheit 30 wird dabei als Iterationsschritt bezeichnet. Es werden so viele Iterationsschritte durchgeführt, bis in der Auswerteeinheit 30 festgestellt wird, daß die empfangenen Daten fehlerfrei dekodiert wurden. Die fehlerfrei dekodierten Daten werden dann als fehlerfrei gekennzeichnet und an einem Datenausgang 35 der Auswerteeinheit 30 für eine Weiterverarbeitung in der Datensenke 45 zur Verfügung gestellt.

Um eine übermäßig große Zahl von Iterationsschritten und damit einen übermäßigen Leistungsverbrauch im Mobiltelefon 1 zu verhindern, kann eine Maximalzahl von Iterationsschritten vorgegeben sein, nach deren Erreichen die Auswerteeinheit 30 unabhängig vom Auftreten von Fehlern in den empfangenen dekodierten Daten die als fehlerhaft markierten Daten am Datenausgang 35 zur Verfügung stellt. Durch geeignete Vorgabe dieser zulässigen Maximalzahl von Iterationsschritten kann ein Kompromiß zwischen einem möglichst geringem Leistungsverbrauch und einer möglichst hohen Fehlerfreiheit der empfangenen dekodierten Daten erzielt werden. Dabei könnte es beispielsweise vorgesehen sein, daß der Benutzer des Mobiltelefons 1 oder ein intelligentes Netzwerk die zulässige Maximalzahl von Iterationsschritten an einer in Figur 1 nicht dargestellten Eingabeeinheit des Mobiltelefons 1 nach seinen Bedürfnissen vorgibt.

Wird für die empfangenen dekodierten Daten in der Auswerteeinheit 30 Fehlerfreiheit bereits nach einer im Vergleich zur vorgegebenen Maximalzahl von Iterationsschritten geringeren Anzahl von Iterationsschritten festgestellt, so wird der Dekodiervorgang im Vergleich zu dem aus der genannten Veröffentlichung von J. Hagenauer bekannten Verfahren vorzeitig abgebrochen, so daß vergleichsweise weniger Leistung verbraucht und die Betriebsdauer für das Mobiltelefon 1 bei Verwendung eines Akkumulators erhöht wird.

In Figur 2 wird anhand eines Ablaufplans das der Übertragung und der Dekodierung zugrundeliegende Verfahren verdeutlicht. Bei einem Programmpunkt 100 werden die in der Datenquelle 40 der Sendeeinheit 50 erzeugten Daten der äußeren Kanalkodierung unter Verwendung eines variablen Blockkodes unterzogen. Anschließend wird zu einem Programmpunkt 105 verzweigt. Bei Programmpunkt 105 werden die so kanalkodierten Daten einer inneren Kanalkodierung, beispielsweise unter Verwendung eines Faltungskodes oder eines Turbo-Kodes unterzogen. Anschließend wird das Programm sendeseitig beendet und zu einem Programmpunkt 110 verzweigt. Bei Programmpunkt 110 werden die kanalkodierten Daten auf dem Übertragungskanal 5 von der Basisstation 50 zum Mobiltelefon 55 übertragen. Empfangsseitig startet nun ein entsprechendes Programm, das beim Programmpunkt 115 des Ablaufplans nach Figur 2 beginnt, der von Programmpunkt 110 aus erreicht wird. Bei Programmpunkt 115 werden die übertragenen Daten im Mobiltelefon 55 empfangen und einer inneren Kanaldekodierung beispielsweise unter Verwendung eines Viterbi-Dekoders oder eines Maximum A Posteriori (MAP) -Dekoders unterzogen. Dabei kann es zu Fehlentscheidungen und damit zu Restfehlern kommen. Anschließend wird zu einem Programmpunkt 120 verzweigt. Bei Programmpunkt 120 werden die so dekodierten empfangenen Daten einer äußeren Kanaldekodierung unterzogen, die den variablen Blockkode dekodiert und dabei bei der inneren Kanaldekodierung aufgetretene Restfehler nicht nur erkennt, sondern zumindest zu einem Teil auch korrigiert. Anschließend wird zu einem Programmpunkt 125 verzweigt.

Bei Programmpunkt 125 prüft die Auswerteeinheit 30, ob die Daten korrekt dekodiert wurden, bzw. ob die Daten nicht mehr fehlerhaft sind. Ist dies der Fall, so wird zu einem Programmpunkt 130 verzweigt, andernfalls wird zu Programmpunkt 115 zurückverzweigt. Bei Programmpunkt 130 werden die empfangenen dekodierten Daten am Datenausgang 35 für eine Weiterverarbeitung abgegeben. Anschließend wird das Programm verlassen. Optional kann es vorgesehen sein, daß der Ablaufplan nach Figur 2 wie beschrieben durchlaufen wird, mit dem Unterschied, daß bei Programmpunkt 125 die Auswerteeinheit 30 prüft, ob die empfangenen dekodierten Daten fehlerfrei sind oder ob die vorgegebene Maximalzahl von Iterationsschritten erreicht wurde. Ist dies der Fall, so wird wieder wie beschrieben zu Programmpunkt 130 verzweigt, andernfalls wird wie beschrieben zu Programmpunkt 115 zurückverzweigt. Auf diese Weise werden die Daten auch dann am Datenausgang 35 abgegeben und die iterative Dekodierung abgebrochen, wenn die vorgegebene Maximalzahl von Iterationsschritten erreicht wurde.

## Patentansprüche

1. Verfahren zur Dekodierung von über einen Übertragungskanal (5) übertragenen kanalkodierten Daten, wobei die Daten vor der Übertragung zunächst mit einem äußeren Kanalkode, vorzugsweise einem Fire-Code, kodiert werden, der sowohl eine Fehlererkennung als auch eine Fehlerkorrektur bei der Dekodierung ermöglicht, wobei die Daten anschließend mit einem inneren Kanalkode, vorzugsweise einem Turbo-Code, kodiert werden, wobei bei der Dekodierung der vom Übertragungskanal (5) empfangenen kanalkodierten Daten in einem ersten Schritt der innere Kanalkode und anschließend in einem zweiten Schritt der äußere Kanalkode dekodiert werden, und wobei bei der Dekodierung des äußeren Kanalkodes zumindest ein Teil der nach der Dekodierung des inneren Kanalkodes verbleibenden Restfehler korrigiert wird**, dadurch gekennzeichnet, daß** in einem dritten Schritt geprüft wird, ob die Daten korrekt dekodiert wurden, daß für den Fall, in dem die Prüfung ergibt, daß die Daten nicht korrekt dekodiert wurden, die Schritte 1 bis 3 wiederholt werden, und daß andernfalls die Dekodierung abgebrochen wird.

2. Verfahren nach Anspruch 1, dadurch gekennzeichnet, daß die Dekodierung abgebrochen wird, wenn im dritten Schritt festgestellt wird, daß eine vorgegebene Anzahl von Iterationsschritten erreicht wurde.

3. Vorrichtung (1) zur Dekodierung von über einen Übertragungskanal (5) übertragenen kanalkodierten Daten, wobei vor der Übertragung eine Kodierung der Daten zunächst durch einen äußeren Kanalkoder (10), der die Daten mit einem äußeren Kanalkode, vorzugsweise einem Fire-Code, kodiert, der sowohl eine Fehlererkennung als auch eine Fehlerkorrektur bei der Dekodierung ermöglicht, und anschließend durch einen inneren Kanalkoder (15), der die Daten mit einem inneren Kanalkode, vorzugsweise einem Turbo-Code, kodiert, erfolgt, wobei ein innerer Kanaldekoder (20) vorgesehen ist, der den inneren Kanalkode der vom Übertragungskanal (5) empfangenen kanalkodierten Daten dekodiert und die so dekodierten Daten einem äußeren Kanaldekoder (25) zuführt, der den äußeren Kanalkode dekodiert, wobei bei der Dekodierung des äußeren Kanalkodes zumindest ein Teil der nach der Dekodierung des inneren Kanalkodes verbleibenden Restfehler korrigiert wird, **dadurch gekennzeichnet, daß** eine Auswerteeinheit (30) vorgesehen ist, die nach Dekodierung des äußeren Kanalkodes prüft, ob die Daten korrekt dekodiert wurden, daß die Auswerteeinheit (30) im Falle nicht korrekt dekodierter Daten diese Daten auf den inneren Kanaldekoder (20) für einen weiteren Iterationsschritt zur Dekodierung rückkoppelt und daß die Auswerteeinheit (30) andernfalls die korrekt dekodierten Daten an einem Datenausgang (35) für eine Weiterverarbeitung zur Verfügung stellt.

4. Vorrichtung nach Anspruch 3, dadurch gekennzeichnet, daß die Auswerteeinheit (30) die dekodierten Daten am Datenausgang (35) für eine Weiterverarbeitung zur Verfügung stellt, wenn eine vorgegebene Anzahl von Iterationsschritten erreicht wurde.
